# EUROPEAN PATENT APPLICATION

(11) **EP 2 736 166 A1**
(43) Date of publication of application: **28.05.2014**
(21) Application number: 12193889.8
(22) Date of filing: 22.11.2012
(51) Int. Cl.: H03F 1/02, H03F 3/195, H03F 3/21, H03F 3/60, H03F 3/217, H03F 3/24

(54) **Power combiner**

(71) Applicant: NXP B.V., 5656 AG Eindhoven (NL)
(72) Inventor: Van Der Heijden, Mark, 5656 AG Eindhoven (NL); Acar, Mustafa, 5656 AG Eindhoven (NL); Apostolidou, Melina, 5656 AG Eindhoven (NL); Wesson, Robin, 5656 AG Eindhoven (NL)
(74) Representative: Schouten, Marcus Maria

(57) **Abstract**

An outphasing power combiner for an outphasing power amplifier is presented. The power combiner comprises first (12) and second (14) distributed active transformer, DAT, combiners each comprising a plurality of transformers and first and second output terminals. The primary winding of each transformer is connected to a respective power source. For each DAT combiner, the secondary windings of the plurality of transformers are connected in series between the first and second output terminals. The first output terminals of the first (12) and second (14) DAT combiners are connected together, and the second output terminals of the first (12) and second (14) DAT combiners are adapted to be connected to a load (Z_{L}).

## Description

### FIELD OF THE INVENTION

This invention relates to the field of power combiners for use in outphasing power amplifiers.

### BACKGROUND

Efficient linear power amplifiers have recently become important for high data-rate and bandwidth-efficient transmission applications. Outphasing power amplifiers are widely known and used for such applications.

An outphasing power amplifier creates a linear modulated signal based on the vector summing of two constant envelope phase modulated signals. A Radio Frequency (RF) signal V(t) containing both amplitude and phase modulation is split into two constant envelope phase modulated signals V1(t) and V2(t) by an outphasing signal generator. High efficiency switching mode power amplifiers are then typically employed to amplify these constant envelope signals, and a power combiner is used to combine the amplified signals.

A power combiner is typically realized by an isolated combiner or a non-isolating combiner. The power-combining efficiency of an isolated combiner is limited by the cancellation of the out-of-phase signals of its two branches. Hence, non-isolating combiners are typically more attractive for use in an outphasing power amplifier due to improved power-combing efficiency.

Traditionally, the non-isolating combiner of an outphasing power amplifier is implemented by two quarter-wave transmission lines. The quarter-wave transmission lines transform the load impedance to the proper impedance for the active device. However, the length of the quarter-wave transmission lines makes practical implementation difficult.

As an alternative, a transformer may be employed as a power combiner. In a conventional transformer-coupled outphasing combiner, the two outphasing signals are combined using the primary side of a transformer, and the combined signal is coupled to the load with the transformer.

It is known to employ a Distributed Active Transformer (DAT) as a power combiner, because a DAT achieves both impedance conversion and power combination. A DAT combiner is also straightforward, compact and suitable for integration in a System-On-Chip (SOC) design. A DAT architecture comprises a plurality N independent power sources and a corresponding plurality N of 1:1 transformers. The N sources are connected to respective primary coils of the N transformers while the N secondary coils of the N transformers are connected in series. AC voltages couple from the N independent power sources through the transformers. These voltages are added together to form the output voltage and achieve an impedance transformation with an N:1 ratio.

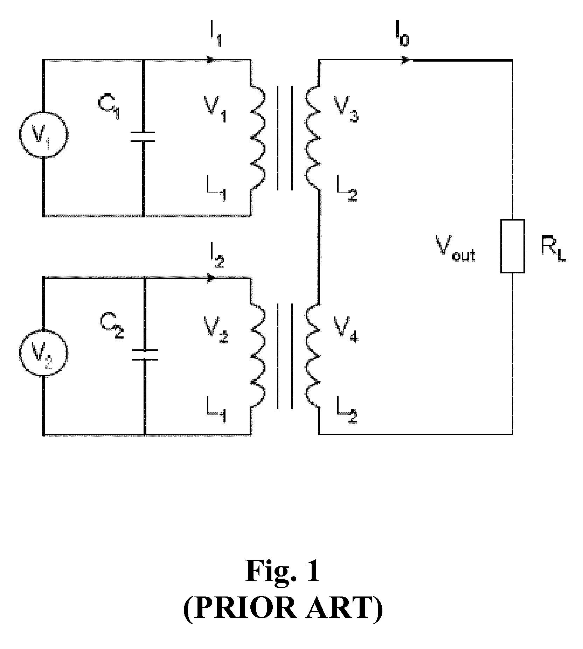

By way of illustration, Figure 1 depicts a DAT combiner for use in an outphasing power amplifier. The DAT comprises first and second independent power sources and first and second transformers. The first and second sources are connected to the respective primary coils/windings of the first and second transformers, and the two secondary coils/windings are connected in series. First V₁ and second V₂ AC voltages are coupled from the first and second sources through the first and second transformers. The constant envelope outphasing signals are applied to the two transformers. Capacitors C1 and C2 are used to create a resonance with equivalent inductor of the respective transformer. The load presented to each source is complex, and the reactive part varies with the outphasing angle θ(t).

The instantaneous efficiency of the outphasing PA is strongly influenced by the power factor (PF) of the combiner, which is defined as the ratio of the power absorbed by the load to the input power of the power combiner. In order to improve the PF, a Chireix version of the combiner uses a parallel reactance to cancel the reactive portion of the power amplifier load for a certain value of θ(t). A parallel reactance used in a Chireix version of the combiner of Figure 1 can be either cancelled or absorbed by C1 and C2.

### BRIEF SUMMARY OF THE INVENTION

According to an embodiment of the invention, there is provided an outphasing power combiner according to independent claim 1.

Embodiments may employ two DAT combiners (otherwise known as class-E power combiners that are transformer-coupled). Such embodiments may ensure that the second harmonic load impedance is insensitive to the outphasing angle, ensuring high-efficiency operation over wider bandwidths. Requirements on an output filter may also be relaxed.

The DATs may be unequal in size (e.g. have windings/coils of different length and/or thickness) to incorporate Chireix compensation elements to maintain high efficiency in back-off.

An outphasing power amplifier may employ an embodiment of the invention. Such a four way outphasing power amplifier may be operated in various ways, the extra paths offering new degrees of freedom of operation and optimisation compared to the conventional two way outphasing architectures.

In one potential mode of operation, adjacent devices can operate as classical push-pull pairs in an outphasing configuration, each push-pull pair taking the place of a single device in a conventional two path outphasing configuration. In another potential mode of operation, the signals to each device can be operated completely independently allowing full control of the phase and amplitude of the two main outphasing vectors, thus enabling wide-band path mismatch correction which is not influenced by combiner asymmetry. In yet another potential mode of operation, the aforementioned two modes can be switched between to provide a phase-only linear back off mode which resolves a key challenge of conventional two path outphasing system, the accuracy with which a null can be created.

Other modes will be evident to one skilled in the art, enabled by the increased degree of freedom provided by embodiments of the invention.

Embodiments may be used to form a four-way transformer-coupled Chireix outphasing power amplifier which enables high dynamic range operation across a wide bandwidth whilst also maintaining high power efficiency in back-off. Amplitude mismatch calibration is the main bandwidth limitation in traditional two-way Chireix outphasing solutions. Additional phase control paths may resolve this issue in the phase domain without introducing additional amplitude to the phase control path employed conventional solutions.

Further, the proposed combiner topology provides a load-insensitive class-E mode of operation in a push-pull configuration, which makes the even harmonic impedances insensitive to the outphasing, thus improving efficiency.

Embodiments may be employed as part of an outphasing power amplifier, as part of an integrated amplifier circuit, or as part of a radio frequency transmitter.

### BRIEF DESCRIPTION OF THE DRAWINGS

Preferred embodiments of the present invention will now be described, by way of example only, with reference to the following drawings in which:
Figure 1 is a schematic circuit diagram of a conventional DAT combiner for use in an outphasing power amplifier;
Figure 2 is a schematic circuit diagram of an outphasing power amplifier according to an embodiment of the invention;
Figure 3 is a graph showing the fundamental output power versus outphasing angle θ for a conventional outphasing power amplifier for various operating frequencies;
Figures 4A and 4B show the variation of the vectors of voltage sources according to an embodiment;
Figure 5 shows an example of how the phases of V1 and V2 may change as a function of the main outphasing angle θ;
Figure 6 is a graph showing the fundamental output power versus outphasing angle θ for an embodiment of the invention for various operating frequencies;
Figure 7 is a graph showing spectral power versus frequency for a conventional outphasing power amplifier and an embodiment of the invention under optimized set of operating conditions;
Figure 8 is a schematic diagram of an outphasing power amplifier comprising a power combiner according to an embodiment of the invention; and
Figure 9 is a schematic diagram of an outphasing power amplifier comprising a power combiner according to another embodiment of the invention.

### DETAILED DESCRIPTION OF THE EMBODIMENTS

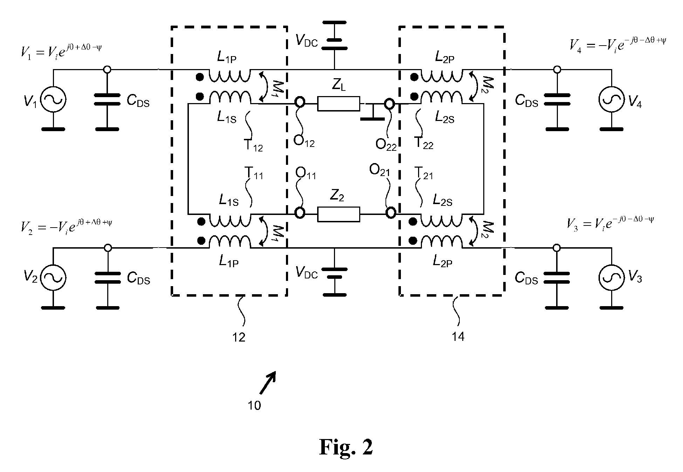

A circuit schematic of an outphasing power amplifier comprising a power combiner 10 according to an embodiment of the invention is shown in Fig. 2. The power combiner comprises first 12 and second 14 DAT power combiners.

The first DAT combiner 12 comprises first T₁₁ and second T₁₂ transformers and first O₁₁ and second O₁₂ output terminals.

The second DAT combiner 14 comprises first T₂₁ and second T₂₂ transformers and first O₂₁ and O₂₂ second output terminals.

It will be understood, that, in Figure 2, the transformers are indicated by a label having the format of T_{XY}, wherein X is "1" or "2" to indicate if the transformer belongs to the first 12 or second 14 DAT, respectively, and wherein Y is "1" or "2" to indicate if the transformer is the first or second transformer of the DAT, respectively. Thus, by way of example, T₁₂ is the second transformer of the first DAT.

The primary winding of each transformer is connected to a respective independent power source. More specifically, the primary winding 1P of the first transformer T₁₁ of the first DAT combiner 12 is connected to a second AC voltage source V₂, the primary winding 1P of the second transformer T₁₂ of the first DAT combiner 12 is connected to a first AC voltage source V₁, the primary winding 1P of the first transformer T₂₁ of the second DAT combiner 14 is connected to a third AC voltage source V₃, and the primary winding 1P of the second transformer T₂₂ of the second DAT combiner 14 is connected to a fourth AC voltage source V₄.

In the first DAT combiner 12, the secondary windings 1S of the first T₁₁ and second T₁₂ transformers are connected in series between the first O₁₁ and O₁₂ second output terminals of the first DAT combiner 12. Similarly, in the second DAT combiner 14, the secondary windings 2S of the first T₂₁ and second T₂₂ transformers are connected in series between the first O₂₁ and O₂₂ second output terminals of the second DAT combiner 14. In other words, for each DAT combiner 12 and 14, the secondary windings of the transformers are connected in series between the first and second output terminals.

The first output terminals O₁₁ and O₂₁ of the first 12 and second 14 DAT combiners, respectively, are connected together via an impedance Z₂.

A load impedance Z_{L} is connected between the second output terminals O₁₂ and O₂₂ of the first 12 and second 14 DAT combiners, respectively. Here, the second output terminal O₂₂ of the second DAT combiner 14 is also connected to ground.

The primary windings 1P of the first transformers T₁₁ and T₂₁ of the first 12 and second 14 DAT combiners are connected together in series between their respective power sources V₂ and V₃. A DC voltage source V_{DC} is connected between ground and a virtual ground point between the primary windings 1P of the first transformers T₁₁ and T₂₁. Similarly, the primary windings 1P of the second transformers T₁₂ and T₂₂ are connected together in series between their respective power sources V₁ and V₄. A DC voltage source V_{DC} is connected between ground and a virtual ground point between the primary windings 1P of the second transformers T₁₂ and T₂₂.

From the above description of the arrangement of Figure 2, it may be appreciated that DAT power combiners 12 and 14 are connected in series in a circular fashion.

In addition to the connections described above, the following features of the embodiment are noted:
Firstly, the transformers are chosen such that they have different values of magnetizing inductance L1 and L2 for the first 12 and second 14 DAT combiners, respectively. In other words, the magnetizing inductance L1 of the transformers T₁₁ and T₁₂ of the first DAT combiner 12 is not equal to the magnetizing inductance L2 of the transformers T₂₁ and T₂₂ of the second DAT combiner 14. This incorporates Chireix compensation into the arrangement.
Secondly, the virtual grounds are decoupled to real grounds to provide a low-ohmic connection of the drain power supplies, which results in a wide-band supply decoupling to minimize any memory effects induced by the nonlinear output capacitance.
Thirdly, the impedance Z₂ connecting the secondary windings of the first and transformers T₁₁ and T₂₁ absorbs leakage inductance of the first transformers T₁₁ and T₂₁, resulting from not-perfect magnetic coupling (i.e. K<1). In its simplest form, this is just a series capacitor that resonates with the leakage inductance of the transformers at a predetermined frequency. This may help to improve power combining properties. Likewise the load-impedance Z_{L} can absorb leakage inductances of the second transformers T₁₂ and T₂₂.

Finally, the output of the combiner itself can act like a balanced-to-unbalanced (balun) circuit through the connection a single-ended load (e.g. Z_{L} is grounded) or the combiner can be connected differentially to an additional balun circuit (e.g Z_{L} left floating).

The operation of the embodiment of Figure 2 is described as follows. For simplicity, it is assumed that switch-mode power amplifier devices are acting like voltage sources. The main outphasing vectors are created by the first balanced pair of voltage sources V₁-V₂ (+θ) and the second balanced pair of voltage sources V₃-V₄ (-θ). Like in the conventional two-way outphasing system, a phase difference Δθ can be prepared in order to correct the phase mismatch between the carriers.

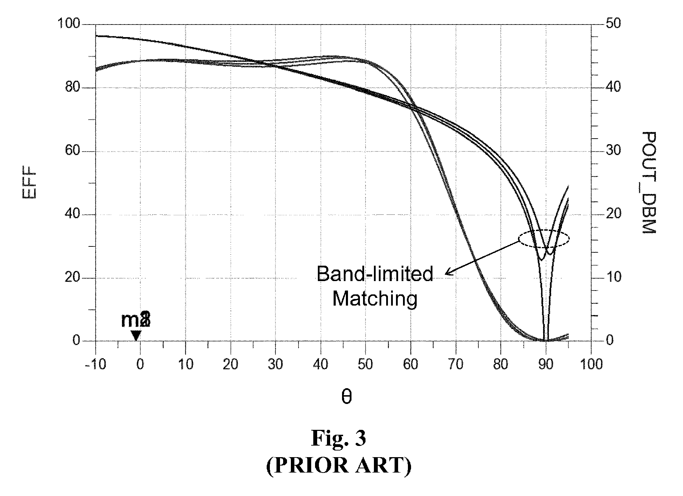

Conventional (two-way) switch-mode outphasing power amplifiers rely on the exact length (amplitude) of the vectors for full cancellation at 2θ=180° outphasing by amplitude matching the class-E power amplifier. In a switch-mode (class-E) power amplifier this can only be done by either offsetting the supply voltages or by offsetting the duty-cycle of each branch power amplifier. However, this is difficult to achieve across wide bandwidths as is indicated in Fig. 3. Figure 3 shows the fundamental output power versus outphasing angle θ for f0=2.11GHz, 2.14GHz and 2.17GHz. At θ=90deg and f0=2.14GHz, the system achieves full cancellation of the outphasing vectors, but at the other frequencies (2.11 and 2.17GHz) the dynamic range is reduced. The only way around would be to control the amplitude match or duty-cycle dynamically to maintain the path matching over a wide bandwidth. This would require a calibrated small-signal polar control loop, which complicates the system dramatically.

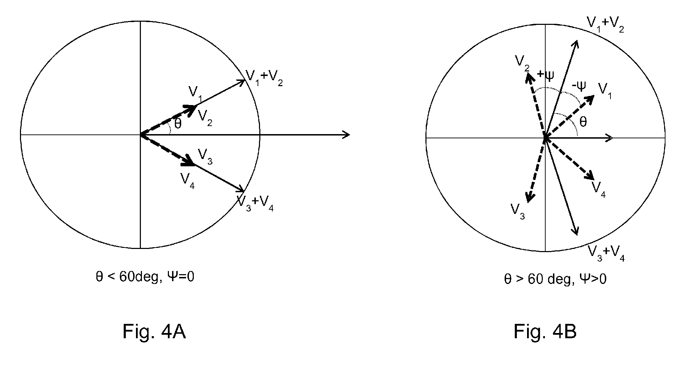

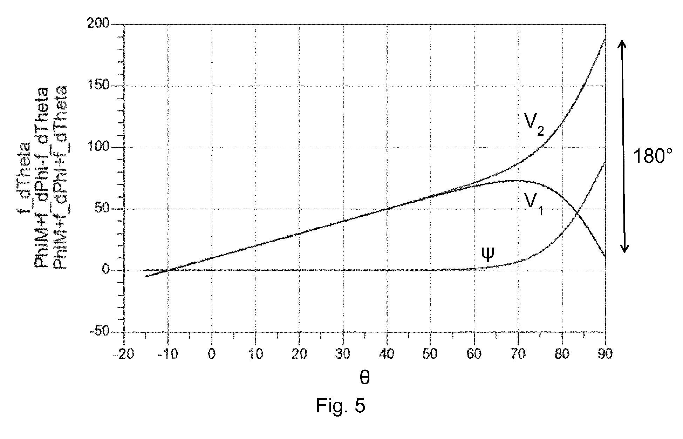

Referring to Figures 4A and 4B, in order to have the additional degree of freedom to control both the amplitude and the phase of the main vectors, the embodiment is adapted to provide another phase ψ that controls the balancing of the push-pull class-E power amplifiers. Typically, beyond θ = 60°, embodiments are adapted to increase ψ from 0→90°, resulting in a power back-off of the main outphasing vectors towards zero amplitude. In other words, it nulls the main outphasing vectors (or cancels the power of each push-pull PA). This provides the required amplitude control directly from the phase domain. Figure 5 shows an example of how the phases of V1 and V2 change as a function of the main outphasing angle θ. Also, ψ as a function of θ is plotted in Figure 5.

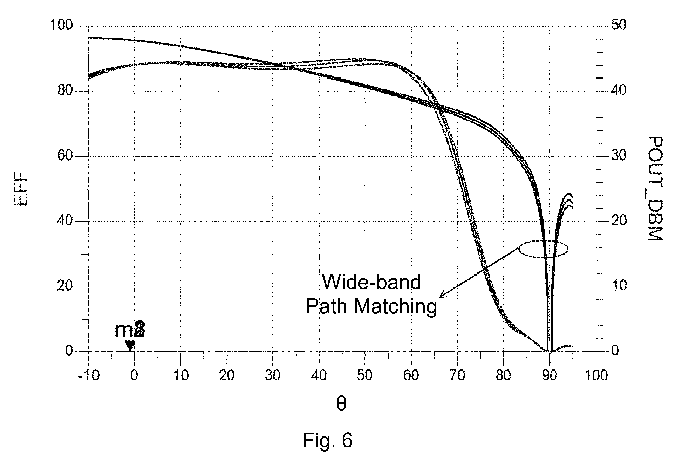

The result is that the vector cancellation can be enforced through the transformer balancing and that the path matching can be maintained across a wide bandwidth, enabling high dynamic range outphasing operation as shown in Fig. 6.

The amplitude path calibration is no more a nonlinear function of frequency, but simply depends on the balance properties of the transformer instead. In this example, the final value of ψ is 90° over the whole band and does not vary with frequency.

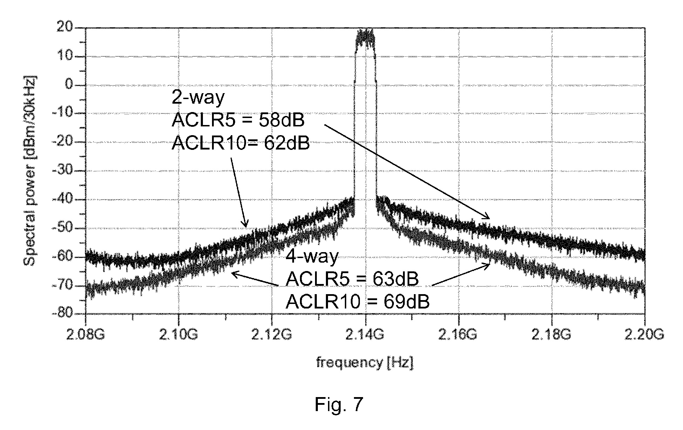

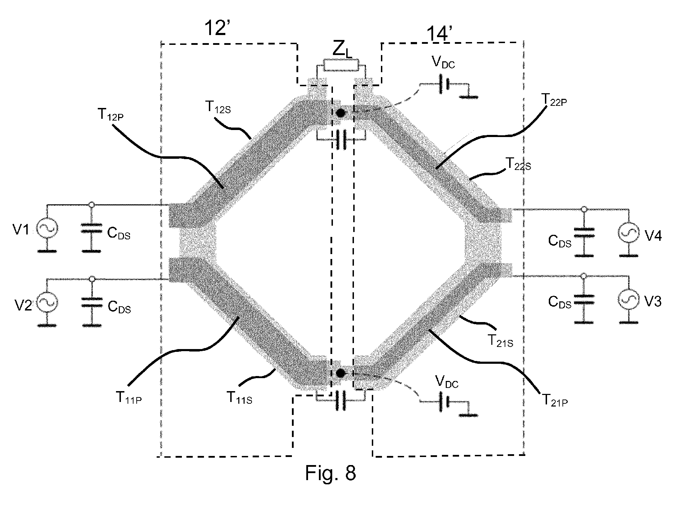

Figures 8 shows the performance of the embodiment of Figure 2 (labelled "4-way") compared to a conventional amplifier (labelled "2-way") when applying a WCDMA signal after linearization. From Figure 7, it can be seen that the conventional two-way outphasing power amplifier has limited signal cancellation at out-of-band frequencies (>30 MHz) compared to the proposed four-way system of Figure 2, which has an overall 10dB lower spectral regrowth.

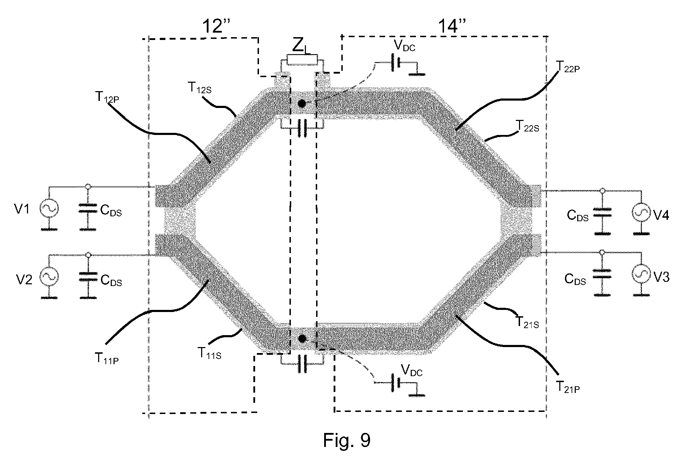

Turning to Figure 8, there is shown an embodiment on the invention in which Chireix compensation is established by DATs 12' and 14' of differing characteristic impedance. In Figure 8 (and Figure 9), the coils are indicated by a label having the format of T_{XYZ}, wherein X is "1" or "2" to indicate if the coil belongs to the first 12 or second 14 DAT, respectively, Y is "1" or "2" to indicate if the coil belongs to the first or second transformer of the DAT, respectively, and Z is "P" or "S" to indicate if the coil is a primary or secondary coil, respectively. By way of example, T_{12S} denotes the secondary coil of the second transformer of the first DAT.

In the embodiment of Figure 8, the primary coils T_{11P} and T_{12P} (shown as darker grey sections) of the transformers of the first DAT 12' are broader in width than the primary coils T_{21P} and T_{22P} of the transformers of the second DAT 14'. In this way, the impedance the transformers of the first DAT 12' differs from that of the transformers of the second DAT 14'. Since the impedances of the first 12' and second 14' DATs are not equal, the DATs may be said to be asymmetric (in characteristic impedance), and it this asymmetry which introduces Chireix compensation into the embodiment so as to maintain high efficiency in back-off.

Figure 9 shows another embodiment in which Chireix compensation is established by DATs of differing electrical length. Here, the coils of the transformers of the second DAT 14" are greater in length than the coils of the transformers of the first DAT 12". In other words, the electrical length of the transformers of the first DAT 12" differs from that of the transformers of the second DAT 14". Since the electrical lengths of the first 12" and second 14" DATs are not equal, the DATs may be said to be asymmetric (in electrical length), and it this asymmetry which introduces Chireix compensation into the embodiment.

Other variations to the disclosed embodiments can be understood and effected by those skilled in the art in practising the claimed invention, from a study of the drawings, the disclosure, and the appended claims. For example,

In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An outphasing power combiner for an outphasing power amplifier comprising:
first and second distributed active transformer, DAT, combiners each comprising a plurality of transformers and first and second output terminals,
wherein the primary winding of each transformer is connected to a respective power source,
wherein, for each DAT combiner, the secondary windings of the plurality of transformers are connected in series between the first and second output terminals,
wherein the first output terminals of the first and second DAT combiners are connected together,
and wherein the second output terminals of the first and second DAT combiners are adapted to be connected to a load.

2. The power combiner of claim 1, wherein the first output terminal of the first and second DAT combiners are connected together via an impedance.

3. The power combiner of claim 3, wherein each DAT combiner comprises first and second transformers.

4. The power combiner of claim 3, wherein the primary windings of the first transformers are connected together in series between their respective power sources, and wherein the primary windings of the second transformers are connected together in series between their respective power sources.

5. The power combiner of any preceding claim, wherein the electromagnetic magnetic coupling factor of the transformers of the first DAT combiner is different from the magnetic coupling factor of the transformers of the second DAT combiner.

6. The power combiner of any preceding claims, wherein, for each DAT combiner, the primary windings of the transformers are substantially equal in length and the secondary windings of the transformers are substantially equal in length.

7. The power combiner of claim 6, wherein the primary and secondary windings of the first DAT are of a different length to the primary and secondary windings of the second DAT combiner.

8. The power combiner of any preceding claims, wherein, for each DAT combiner, the primary windings of the transformers are substantially equal in width and the secondary windings of the transformers are substantially equal in width.

9. The power combiner of claim 8, wherein the primary and secondary windings of the first DAT combiner are of a different width to the primary and secondary windings of the second DAT combiner.

10. An outphasing power amplifier comprising an outphasing power combiner according to any preceding claim.

11. An integrated amplifier circuit comprising an outphasing power combiner according to any of claims 1 to 9.

12. A radio frequency transmitter comprising an outphasing power combiner according to any of claims 1 to 9.
